# EUROPEAN PATENT APPLICATION

(11) **EP 4 617 820 A1**
(43) Date of publication of application: **17.09.2025**
(21) Application number: 22967661.4
(22) Date of filing: 09.12.2022
(51) Int. Cl.: G05D 23/19, H01M 8/04007

(54) **INTEGRATED DEVICE, COOLING SYSTEM, COOLING METHOD AND TERMINAL**

(71) Applicant: Shenzhen Yinwang Intelligent Technologies Co., Ltd., Shenzhen, Guangdong 518129 (CN)
(72) Inventor: PENG, Yaofeng, Shenzhen, Guangdong 518129 (CN); WU, Bin, Shenzhen, Guangdong 518129 (CN); LIU, Chaopeng, Shenzhen, Guangdong 518129 (CN)
(74) Representative: Pfenning, Meinig & Partner mbB
(86) International application number: PCT/CN2022/138128
(87) International publication number: WO 2024/119514

(57) **Abstract**

Embodiments of this application provide an integrated apparatus, a cooling system, a cooling method, and a terminal. The integrated apparatus includes a circuit board, a temperature sensor, and a humidity sensor. A dew point temperature of an environment in the integrated apparatus is calculated based on a temperature and humidity measured by the temperature sensor and the humidity sensor, and a cooling mode of the integrated apparatus is selected based on the dew point temperature, to avoid generating condensation. The cooling system includes the integrated apparatus, a cooling pipe, a valve, and a heat exchange medium. Opening/Closing of the valve controls whether the heat exchange medium circulates in the cooling pipe, and controls the cooling mode of the integrated apparatus, to avoid generating condensation and prevent from a short circuit in the circuit board. According to the solution provided in this application, the integrated apparatus requires only IP52 rating, eliminating the need for a ventilation valve, adhesive dispensing sealing, or a reversible moisture-absorbing material. There is no need to apply a waterproof coating on the circuit board. This reduces manufacturing and maintenance costs of the integrated apparatus, facilitates disassembly, ensures good heat dissipation performance, and contributes to enhanced performance of the integrated apparatus.

## Description

### TECHNICAL FIELD

This application relates to the field of electronic devices, and in particular, to an integrated apparatus, a cooling system, a cooling method, and a terminal.

### BACKGROUND

As the autonomous driving level becomes higher, computing power and power consumption of a system on chip SoC (system on chip) on a vehicle-mounted intelligent module are also higher. Conventional natural heat dissipation or air cooling heat dissipation cannot meet a heat dissipation requirement of the SoC, and liquid cooling heat dissipation needs to be performed on the SoC. When a temperature of coolant is lower than an ambient temperature, condensation may be generated, which may cause a short circuit in a circuit board. In addition, when air humidity is high or the ambient temperature is low, condensation may also be generated, which may cause a short circuit in the circuit board.

### SUMMARY

This application provides an integrated apparatus, a cooling system, a cooling method, and a terminal, to prevent a circuit board from being short-circuited due to condensation.

According to a first aspect, an embodiment of this application provides an integrated apparatus. The integrated apparatus includes a circuit board, a first temperature sensor, and a humidity sensor. The first temperature sensor is configured to measure a temperature, and humidity sensor is configured to measure humidity. The temperature and the humidity are used to obtain a dew point temperature of an environment in the integrated apparatus, and the dew point temperature is used to determine a cooling mode of the integrated apparatus. The dew point temperature is related to an ambient temperature and ambient humidity, and the dew point temperature may be obtained by measuring the ambient temperature and the ambient humidity. If there is a risk of condensation when the integrated apparatus is cooled through liquid cooling at a dew point temperature of a current environment, the integrated apparatus is cooled in another cooling mode, to avoid a short circuit in the circuit board due to condensation.

In a possible implementation of the first aspect, the integrated apparatus further includes a first processing module. The first processing module is configured to calculate the dew point temperature based on the temperature and the humidity. The integrated apparatus determines the cooling mode based on the dew point temperature, to avoid generating condensation.

In a possible implementation of the first aspect, the first temperature sensor is located on the circuit board. The first temperature sensor is integrated into the circuit board, and is configured to measure the temperature, to obtain the ambient dew point temperature.

In a possible implementation of the first aspect, the humidity sensor is located on the circuit board. The humidity sensor is integrated into the circuit board, and is configured to measure the humidity to obtain the ambient dew point temperature.

In a possible implementation of the first aspect, the integrated apparatus further includes a cooling plate and a second temperature sensor. The cooling plate is used for heat exchange of the integrated apparatus, and the second temperature sensor is configured to measure a temperature of the cooling plate. The cooling plate is used by the integrated apparatus to perform heat exchange, and is a part with a condensation risk. The second temperature sensor measures the temperature of the cooling plate, so that a condensation risk can be more accurately determined. When the temperature of the cooling plate is higher than the dew point temperature, there is no condensation risk. When the temperature of the cooling plate is lower than the dew point temperature, there is a condensation risk. The cooling mode of the integrated apparatus may be determined based on the temperature.

The integrated apparatus provided in this embodiment of this application measures the temperature and the humidity via the temperature sensor and the humidity sensor, calculates the dew point temperature based on the measured temperature and the measured humidity, determines a condensation risk based on the dew point temperature, and selects a proper cooling mode to avoid the condensation risk. According to the solution provided in this application, the integrated apparatus requires only IP52 rating, and does not require a ventilation valve, adhesive dispensing sealing, or a reversible moisture-absorbing material. This reduces manufacturing costs of the integrated apparatus. Because the integrated module does not need to be sealed, and there is no need to apply a waterproof coating on the circuit board, the integrated apparatus provided in this embodiment of this application is easy to disassemble and has high maintainability. In addition, because there is no need to apply a waterproof coating on the circuit board, the circuit board has good heat dissipation performance, contributing to enhanced performance of the integrated apparatus. According to a second aspect, an embodiment of this application provides a cooling system. The cooling system includes the integrated apparatus according to any one of the first aspect, a cooling pipe, a valve, and a heat exchange medium. The cooling pipe is configured to circulate the heat exchange medium, the heat exchange medium is configured to dissipate heat from the integrated apparatus, and the valve is configured to control opening/closing of the cooling pipe. When the valve is opened, the heat exchange medium circulates in the cooling pipe, and the integrated apparatus is in a liquid cooling heat dissipation state. When the valve is closed, the heat exchange medium does not circulate in the cooling pipe, and the integrated apparatus is in another heat dissipation state like natural heat dissipation or air cooling heat dissipation. In other words, in this case, the integrated apparatus performs heat dissipation in a cooling mode like natural heat dissipation or air cooling heat dissipation.

In a possible implementation of the second aspect, the cooling system further includes a second processing module. When a temperature of the heat exchange medium is higher than a dew point temperature, or a temperature of the heat exchange medium is higher than a sum of a dew point temperature and a first threshold, the second processing module is configured to control the valve to be opened. When the temperature of the heat exchange medium is higher than the dew point temperature, or the temperature of the heat exchange medium is higher than the sum of the dew point temperature and the first threshold, no condensation is generated, and the valve is opened to enable the heat exchange medium to circulate in the cooling pipe, so as to dissipate heat from the integrated apparatus, and ensure that the integrated apparatus operates properly.

In a possible implementation of the second aspect, the first threshold is related to performance of a temperature sensor and/or a humidity sensor. A temperature and humidity measured by the temperature sensor and the humidity sensor may have errors. To ensure that no condensation is generated in the integrated apparatus, the first threshold is set, to prevent a measured dew point temperature from being lower than an actual dew point temperature, which may be misjudged as no condensation risk. As a result, the integrated apparatus is in a liquid cooling state and condensation is generated.

In a possible implementation of the second aspect, when the temperature of the heat exchange medium is not higher than the dew point temperature, or the temperature of the heat exchange medium is not higher than the sum of the dew point temperature and the first threshold, the valve is closed. When the temperature of the heat exchange medium does not meet a condition, there is a risk of condensation. The valve is closed, so that the integrated apparatus is in another heat dissipation state like a natural heat dissipation state or an air cooling state, to prevent condensation.

In a possible implementation of the second aspect, the cooling system further includes a third temperature sensor, and the third temperature sensor is configured to measure the temperature of the heat exchange medium. A condensation risk may be determined based on the measured temperature of the heat exchange medium, and a cooling mode of the integrated apparatus may be determined.

According to a third aspect, an embodiment of this application provides a cooling method, applied to a cooling system. The cooling system includes an integrated apparatus, a cooling pipe, a valve, and a heat exchange medium. After the integrated apparatus is powered on for first duration, the valve is opened, the heat exchange medium circulates in the cooling pipe, and the heat exchange medium dissipates heat from the integrated apparatus. When the integrated apparatus is powered on, a temperature of the heat exchange medium is low. In this case, when the heat exchange medium circulates to dissipate heat from the integrated apparatus, there is a risk of condensation. After the first duration, the temperature of the heat exchange medium rises to a temperature higher than a dew point temperature, the valve is opened so that the heat exchange medium circulates in the cooling pipe, to dissipate heat from the integrated apparatus, and no condensation is generated.

According to a fourth aspect, an embodiment of this application provides a cooling method, applied to a cooling system. The cooling system includes an integrated apparatus, a cooling pipe, a valve, and a heat exchange medium. An external ambient temperature of the integrated apparatus is obtained, and the valve is closed when the external ambient temperature of the integrated apparatus is less than a second threshold. When the ambient temperature is less than the second threshold, another heat dissipation mode like natural heat dissipation or air cooling heat dissipation can meet a heat dissipation requirement of the integrated apparatus. The valve is closed, so that the heat exchange medium cannot circulate in the cooling pipe, and there is no condensation risk.

In a possible implementation of the fourth aspect, when the ambient temperature is not less than the second threshold, and power-on duration of the integrated apparatus is greater than first duration, the valve is opened, the heat exchange medium circulates in the cooling pipe, and the heat exchange medium then dissipates heat from the integrated apparatus. When the ambient temperature is not less than the second threshold, and another heat dissipation mode like natural heat dissipation or air cooling heat dissipation cannot meet a heat dissipation requirement of the integrated apparatus, liquid cooling heat dissipation needs to be performed on the integrated apparatus. When the power-on duration of the integrated apparatus is greater than the first duration, the temperature of the heat exchange medium rises to a temperature higher than the dew point temperature, the valve is opened so that the heat exchange medium circulates in the cooling pipe, to dissipate heat from the integrated apparatus, and no condensation is generated.

According to a fifth aspect, an embodiment of this application provides a cooling method, applied to an integrated apparatus. The integrated apparatus includes a circuit board, a first temperature sensor, and a humidity sensor. The first temperature sensor is configured to measure a temperature, and humidity sensor is configured to measure humidity. The temperature and the humidity are used to obtain a dew point temperature of an environment in the integrated apparatus, and the dew point temperature is used to determine a cooling mode of the integrated apparatus.

According to a sixth aspect, an embodiment of this application provides a cooling method, applied to a cooling system. The cooling system includes the integrated apparatus according to any one of the first aspect, a cooling pipe, a valve, and a heat exchange medium. The cooling pipe is configured to circulate the heat exchange medium, the heat exchange medium is configured to dissipate heat from the integrated apparatus, and the valve is configured to control opening/closing of the cooling pipe. When the valve is opened, the heat exchange medium circulates in the cooling pipe, and the integrated apparatus is in a liquid cooling heat dissipation state. When the valve is closed, the heat exchange medium does not circulate in the cooling pipe, and the integrated apparatus is in another heat dissipation state like natural heat dissipation or air cooling heat dissipation.

According to a seventh aspect, an embodiment of this application provides a terminal. The terminal includes the integrated apparatus or the cooling system according to any one of the first aspect or the second aspect. Optionally, the terminal is a vehicle.

According to an eighth aspect, an embodiment of this application provides a computer-readable storage medium. When the computer-readable storage medium is executed on a computer or a processor, the method according to any one of the third aspect, the fourth aspect, the fifth aspect, or the sixth aspect is performed.

For implementation effect brought by the implementations corresponding to the fifth aspect, the sixth aspect, the seventh aspect, and the eighth aspect, refer to the descriptions of the implementations of the first aspect and the second aspect. Details are not described herein again.

### BRIEF DESCRIPTION OF DRAWINGS

FIG. 1 is a diagram of a use scenario of an integrated apparatus;
FIG. 2 is a diagram of an integrated apparatus according to this application;
FIG. 3 is another diagram of an integrated apparatus according to this application;
FIG. 4 is still another diagram of an integrated apparatus according to this application;
FIG. 5 is yet another diagram of an integrated apparatus according to this application;
FIG. 6 is still yet another diagram of an integrated apparatus according to this application;
FIG. 7 is a further diagram of an integrated apparatus according to this application;
FIG. 8 is a diagram of a cooling system according to this application;
FIG. 9 is another diagram of a cooling system according to this application;
FIG. 10 is a diagram of applying a cooling system to a vehicle according to this application;
FIG. 11 is still another diagram of a cooling system according to this application;
FIG. 12 is a schematic flowchart of a cooling method according to this application;
FIG. 13 is another schematic flowchart of a cooling method according to this application; and
FIG. 14 is still another schematic flowchart of a cooling method according to this application.

### DESCRIPTION OF EMBODIMENTS

To make objectives, technical solutions, and advantages of embodiments of this application clearer, the following further describes embodiments of this application in detail with reference to accompanying drawings.

For ease of understanding, some concepts related to embodiments of this application are described below for reference by using examples. Details are as follows.

### 1. Integrated apparatus

The integrated apparatus mentioned in embodiments of this application may be an intelligent driving module, a vehicle-mounted infotainment module, a vehicle control module, a mobile data center (Mobile Data Center, MDC), an intelligent cockpit domain controller (Cockpit Domain Controller, CDC), a vehicle domain controller (Vehicle Domain Controller), or another module unit encapsulated with an integrated circuit in the vehicle-mounted field, for example, an electronic control unit (Electronic Control Unit, ECU), a telematics box (Telematics Box, Tbox), or an industrial personal computer (Industrial Personal Computer, IPC). The integrated apparatus in embodiments of this application can be used in various fields such as intelligent driving, intelligent transportation, intelligent manufacturing, intelligent control, and environment monitoring, and can complete one or more functions of data processing, automatic control, information collection, simulation calculation, target recognition, and the like.

### 2. Circuit board

The circuit board may also be referred to as a line board, a PCB board, an FPC line board, a printed line board, a mainboard, or the like. The circuit board is a printed board on which point connections and printed elements are formed on a substrate based on a predetermined design. A function of the circuit board is to form a predetermined circuit connection between electronic components, and the circuit board is a substrate and a key interconnection component on which the electronic components are installed.

The circuit board is installed in the integrated apparatus, and the circuit board and the electronic components integrated into the board form a whole, which is a core for implementing a function of the integrated apparatus.

### 3. Temperature sensor

The temperature sensor (Temperature sensor) is a sensor that senses a temperature and converts the temperature into an available output signal.

4. A humidity sensor (Humidity sensor) is a sensor that senses a temperature and converts the temperature into an available output signal.

### Humidity sensor

### 5. Heat exchange medium

The heat exchange medium may also be referred to as a heat transfer medium, a heat exchange working medium, or the like, and is configured to transfer heat from one place to another. The heat exchange medium is usually gas or liquid, like air, water, or oil, or may be a phase change material or liquid metal, or may be a nanofluid formed by dispersing metal or non-metal nanoparticles into a fluid medium.

### 6. Dew point temperature

The dew point temperature is also referred to as a dew point (Dew point), and is a temperature at which gaseous water in the air reaches saturation and condenses into liquid water under a fixed atmospheric pressure. Gaseous water on a solid surface condenses into dew at this temperature, and therefore the temperature is referred to as a dew point temperature.

At a fixed atmospheric pressure, the dew point is related to a temperature and humidity. When water vapor in the air reaches saturation, the dew point is the same as the temperature.

### 7. Valve

The valve is a movable component and an apparatus that can be used to open, close, or partially obstruct one or more openings or passageways so that liquid flow, air flow, or other loose materials can flow out, be blocked, or be regulated. The valve may be classified into a manual valve, an electric valve, a hydraulic valve, and an atmospheric pressure valve based on the driving mode.

### 8. Cooling plate

In the integrated apparatus or a cooling system, a component configured to perform heat exchange for heat dissipation is usually made of metal or a non-metal material with good thermal conductivity, for example, copper, aluminum, or carbon. The cooling plate may be hollow to circulate the heat exchange medium. Alternatively, the cooling plate may be a physical structure, and there may be a structure like a heat dissipation fin on the cooling plate.

The cooling plate may alternatively be formed by deformation of a cooling pipe, or may be a part of the cooling pipe. The cooling plate is usually in contact with a heat generation part in the apparatus, and dissipates heat from the cooling plate through heat exchange.

### 9. Cooling pipe

The cooling pipe may also be referred to as a heat pipe, and is a heat transfer element. A heat exchange medium circulates in the cooling pipe, and is configured to quickly transfer heat of a heat-generating object to the outside of a heat source.

In embodiments of this application, unless otherwise specified, a quantity of nouns represents "a singular noun or a plural noun", that is, "one or more". "At least one" means one or more, and "a plurality of" means two or more. "And/or" describes an association relationship between associated objects and indicates that three relationships may exist. For example, A and/or B may indicate the following three cases: Only A exists, both A and B exist, and only B exists, where A and B may be singular or plural. Unless otherwise specified, the character "/" generally indicates an "or" relationship between the associated objects. For example, A/B indicates A or B. "At least one of the following items (pieces)" or a similar expression thereof means any combination of these items, including a single item (piece) or any combination of a plurality of items (pieces). For example, at least one item (piece) of a, b, or c may represent: a, b, c, a and b, a and c, b and c, or a, b, and c. Herein, a, b, and c may be singular or plural.

Ordinal numerals such as "first" and "second" in embodiments of this application are used to distinguish between a plurality of objects, and are not intended to limit sizes, content, orders, time sequences, application scenarios, priorities, or importance of the plurality of objects. For example, a first processing module and a second processing module may be a same processing module, or may be different processing modules. In addition, the names do not indicate that structures, locations, priorities, application scenarios, importance degrees, or the like of the two processing modules are different.

In embodiments of this application, "connection" may be a direct connection or an indirect connection. In addition, "connection" may be an electrical connection or a communication connection. For example, that two electrical elements A and B are connected may mean that A and B are directly connected, or may mean that A and B are indirectly connected through another electrical element or a connection medium, so that an electrical signal can be transmitted between A and B. For another example, that two devices A and B are connected may mean that A and B are directly connected, or may mean that A and B are indirectly connected through another communication device or a communication medium, provided that A and B can communicate with each other.

In embodiments of this application, unless otherwise stated or there is a logic conflict, terms and/or descriptions between embodiments are consistent and may be mutually referenced, and technical features in different embodiments may be combined into a new embodiment based on an internal logical relationship thereof.

A person of ordinary skill in the art may understand that all or some of the steps of the embodiments may be implemented by hardware or a program instructing related hardware. The program may be stored in a computer-readable storage medium. The storage medium may be a read-only memory, a magnetic disk, an optical disc, or the like.

The foregoing describes some concepts in embodiments of this application, and the following describes technical features in embodiments of this application.

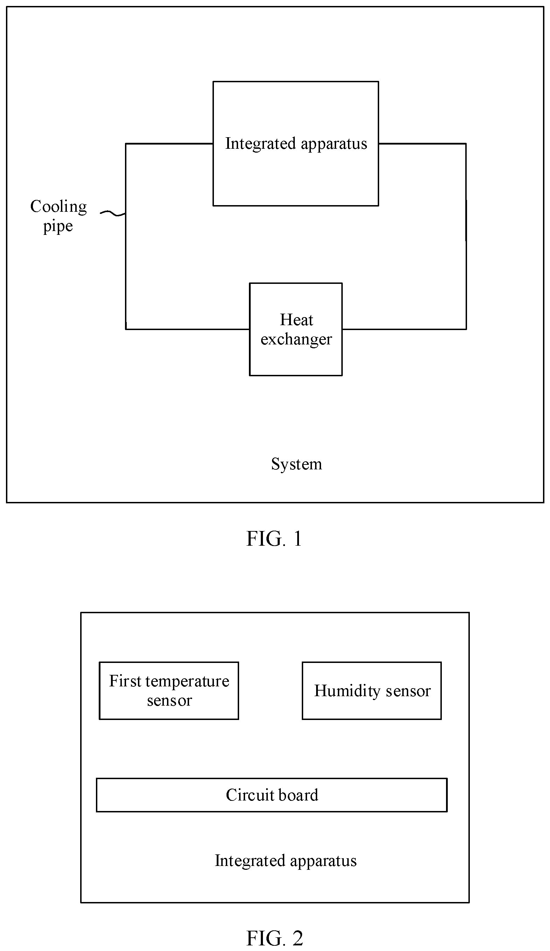

FIG. 1 is a diagram of a use scenario of an integrated apparatus. The integrated apparatus generates heat during operation, and a heat exchange medium in a cooling pipe needs to dissipate heat from the integrated apparatus, to ensure that the integrated apparatus is not shut down or even burnt due to overheating. The heat exchange medium absorbs heat in the integrated apparatus, and the heat absorbed by the heat exchange medium is released by a heat exchanger, to dissipate heat from the integrated apparatus. When a temperature of the heat exchange medium is lower than a dew point temperature, condensation may be generated on the integrated apparatus. If the condensation drops on a circuit board of the integrated apparatus, there is a risk of a short circuit.

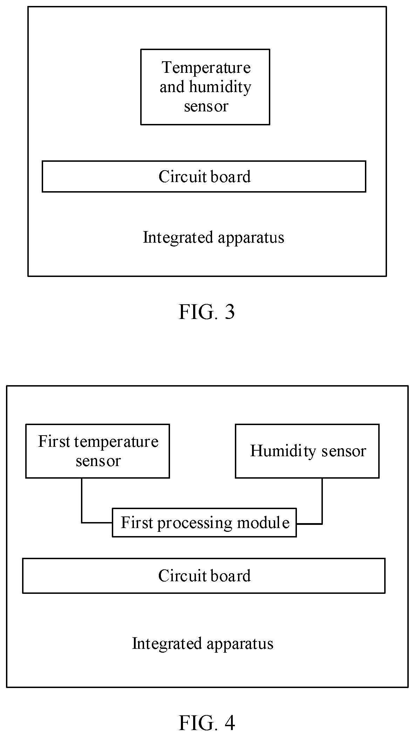

Therefore, this application provides an integrated apparatus. FIG. 2 is a diagram of an integrated apparatus according to this application. The integrated apparatus includes a circuit board, a first temperature sensor, and a humidity sensor. The first temperature sensor and the humidity sensor are located in the integrated apparatus. The first temperature sensor and the humidity sensor are configured to measure a temperature and humidity in the integrated apparatus, obtain a dew point temperature based on the temperature and the humidity, and determine a cooling mode of the integrated apparatus based on the dew point temperature. If liquid cooling is used to cool the integrated apparatus at a current dew point temperature, there is a risk of condensation. In this case, heat dissipation is performed on the integrated apparatus in another cooling mode, to avoid a short circuit of the integrated apparatus due to condensation. Optionally, the first temperature sensor and the humidity sensor may be different sensors, or may be a temperature and humidity sensor that can measure both a temperature and humidity. FIG. 3 is a diagram of an integrated apparatus according to this application. The temperature and humidity sensor is both the first temperature sensor and the humidity sensor.

In a possible implementation, the first temperature sensor is integrated into the circuit board.

In a possible implementation, the humidity sensor is integrated into the circuit board.

In a possible implementation, FIG. 4 is a diagram of an integrated apparatus according to this application. The integrated apparatus further includes a first processing module. The first processing module is connected to the first temperature sensor and the humidity sensor. The first processing module is configured to calculate the dew point temperature based on the temperature data and the humidity data.

In a possible implementation, the first processing module is integrated into the circuit board.

Optionally, the dew point temperature may be calculated according to a Goff-Gratch equation, or may be calculated according to a Magnus formula, or may be obtained in a form of table lookup or the like. This is not limited in this application. The processing module may include one or more processors. It should be understood that, in embodiments of this application, for ease of describing a calculation function, the processing module is described as a processor. In a specific implementation process, the processor may include an apparatus having a calculation function. For example, at least one processor may include one or more of the following apparatuses: a central processing unit (central processing unit, CPU), an application processor (application processor, AP), a time-to-digital converter (Time-to-Digital Converter, TDC), a filter, a graphics processing unit (graphics processing unit, GPU), a microprocessor (microprocessor unit, MPU), an application specific integrated circuit (Application Specific Integrated Circuit, ASIC), an image signal processor (image signal processor, ISP), a digital signal processor (digital signal processor, DSP), a field programmable gate array (Field Programmable Gate Array, FPGA), a complex programmable logic device (Complex programmable logic device, CPLD), a coprocessor (assisting a central processing unit to complete corresponding processing and application), a microcontroller unit (Microcontroller Unit, MCU), a neural-network processing unit (neural-network processing unit, NPU), and/or the like.

Optionally, the processing module may be located inside the integrated apparatus, or may be located outside the integrated apparatus.

Alternatively, in some possible designs, the processing module may include a plurality of components, some components are located inside the integrated apparatus, and some components are located outside the integrated apparatus. For example, the processing module may include a digital-to-analog conversion module, a filtering module, and an output module. The digital-to-analog conversion module and the filtering module are located inside the integrated apparatus, and the output module is located outside the integrated apparatus.

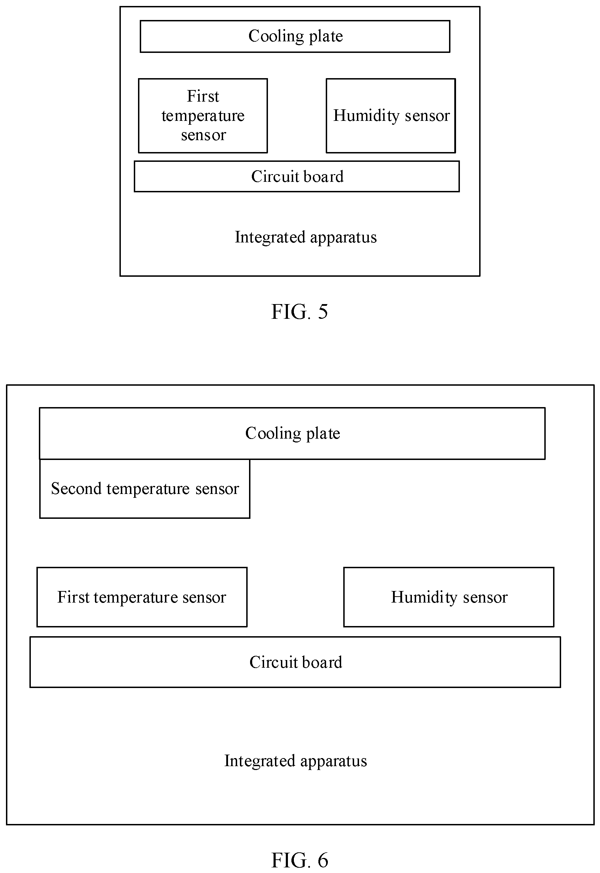

In a possible implementation, FIG. 5 is a diagram of an integrated apparatus according to this application. The integrated apparatus further includes a cooling plate. The cooling plate is used by the integrated apparatus to perform heat exchange, and is a part with a condensation risk. When a temperature of the cooling plate is higher than the dew point temperature, there is no condensation risk. When the temperature of the cooling plate is lower than the dew point temperature, there is a condensation risk. In this case, the cooling mode of the integrated apparatus may be determined based on the temperature. When there is the condensation risk, the integrated apparatus uses another heat dissipation mode like natural heat dissipation or air cooling heat dissipation. When there is no condensation risk, the integrated apparatus uses a liquid cooling heat dissipation mode.

In a possible implementation, FIG. 6 is a diagram of an integrated apparatus according to this application. The integrated apparatus further includes a cooling plate and a second temperature sensor. The integrated apparatus further includes the cooling plate, and the cooling plate is configured to perform heat exchange with the integrated apparatus. The cooling plate is a part with a condensation risk. When a temperature of the cooling plate is higher than the dew point temperature, there is no condensation risk. When the temperature of the cooling plate is lower than the dew point temperature, there is a condensation risk. In this case, the cooling mode of the integrated apparatus may be determined based on the temperature. When there is the condensation risk, the integrated apparatus uses another heat dissipation mode like natural heat dissipation or air cooling heat dissipation. When there is no condensation risk, the integrated apparatus uses a liquid cooling heat dissipation mode. The second temperature sensor and the first temperature sensor may be a same temperature sensor, or may be different temperature sensors. In addition, the names do not indicate that structures, locations, priorities, application scenarios, importance degrees, or the like of the two temperature sensors are different.

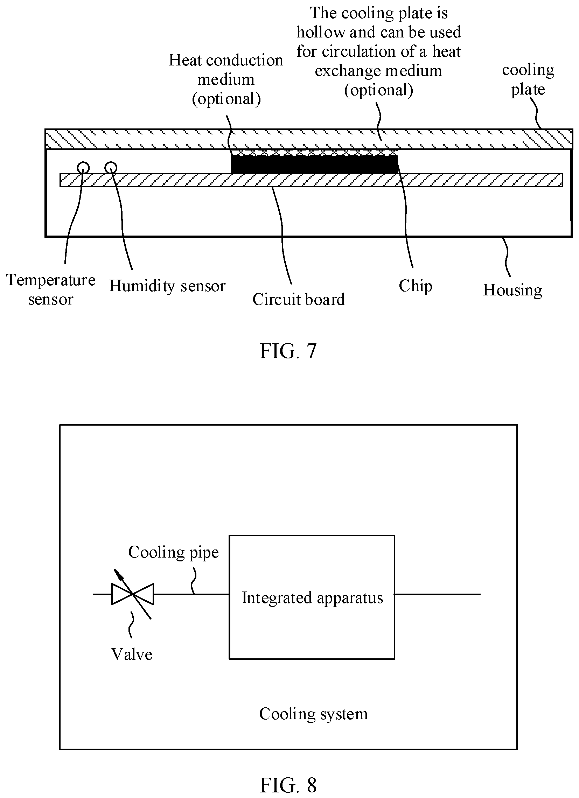

In a possible implementation, FIG. 7 is a diagram of an integrated apparatus according to an embodiment of this application. The integrated apparatus includes a housing, a circuit board, a chip, a temperature sensor, a humidity sensor, and a cooling plate. The chip is a main heat source in the integrated apparatus, and the cooling plate is connected to the chip to dissipate heat from the chip. The housing surrounds an electronic component like the circuit board, and has a packaging function. Optionally, the cooling plate may be hollow to circulate a heat exchange medium, or may be of a solid structure. The cooling plate may be in direct contact with a heat generation part in the integrated apparatus, or may be connected to the heat generation part in the integrated apparatus via another heat conduction medium. Optionally, the heat conduction medium may be a thermally conductive pad, thermally conductive silicone grease, or the like. The heat conduction medium may fill a gap between the cooling plate and the chip, to help improve heat conduction efficiency, and may also provide a specific protection function for the chip, to provide a buffer between the cooling plate and the chip, and prevent the cooling plate from damaging the chip during assembly or use.

The integrated apparatus provided in this embodiment of this application measures a temperature and humidity via the temperature sensor and the humidity sensor, calculates a dew point temperature based on the measured temperature and the measured humidity, determines a condensation risk based on the dew point temperature, and selects a proper cooling mode to avoid the condensation risk. According to the solution provided in this application, the integrated apparatus requires only IP52 rating, and does not require a ventilation valve, adhesive dispensing sealing, or a reversible moisture-absorbing material. This reduces manufacturing costs of the integrated apparatus. Because the integrated module does not need to be sealed, and there is no need to apply a waterproof coating on the circuit board, the integrated apparatus provided in this embodiment of this application is easy to disassemble and has high maintainability. In addition, because there is no need to apply a waterproof coating on the circuit board, the circuit board has good heat dissipation performance, contributing to enhanced performance of the integrated apparatus.

This application provides a cooling system. FIG. 8 is a diagram of the cooling system provided in this application. The cooling system includes the integrated apparatus according to any one of the first aspect, a cooling pipe, a valve, and a heat exchange medium. The cooling pipe is configured to circulate the heat exchange medium, the heat exchange medium is configured to dissipate heat from the integrated apparatus, and the valve is configured to control opening/closing of the cooling pipe. When the valve is opened, the heat exchange medium circulates in the cooling pipe, and the integrated apparatus is in a liquid cooling heat dissipation state. When the valve is closed, the heat exchange medium does not circulate in the cooling pipe, and the integrated apparatus is in another heat dissipation state like natural heat dissipation or air cooling heat dissipation. Opening/Closing of the valve is determined based on a cooling mode required by the integrated apparatus. When the integrated apparatus has no condensation risk, the valve is opened, and the integrated apparatus is in the liquid cooling heat dissipation state. When the integrated apparatus has a condensation risk, the valve is closed, and the integrated apparatus is in another heat dissipation state like natural heat dissipation or air cooling heat dissipation, to avoid generating condensation.

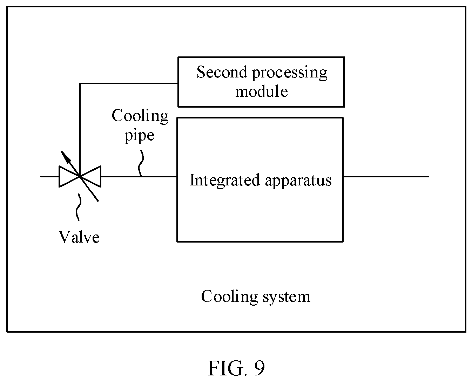

In a possible implementation, FIG. 9 is a diagram of a cooling system according to this application. The cooling system further includes a second processing module, and the second processing module is connected to the valve. When a temperature of the heat exchange medium is higher than a dew point temperature, or a temperature of the heat exchange medium is higher than a sum of a dew point temperature and a first threshold, the second processing module controls the valve to be opened. When the temperature of the heat exchange medium is higher than the dew point temperature, or the temperature of the heat exchange medium is higher than the sum of the dew point temperature and the first threshold, no condensation is generated, and the valve is opened to enable the heat exchange medium to circulate in the cooling pipe, so as to dissipate heat from the integrated apparatus, and ensure that the integrated apparatus operates properly. The second processing module and a first processing module may be a same processing module, or may be different processing modules. In addition, the names do not indicate that structures, locations, priorities, application scenarios, importance degrees, or the like of the two processing modules are different.

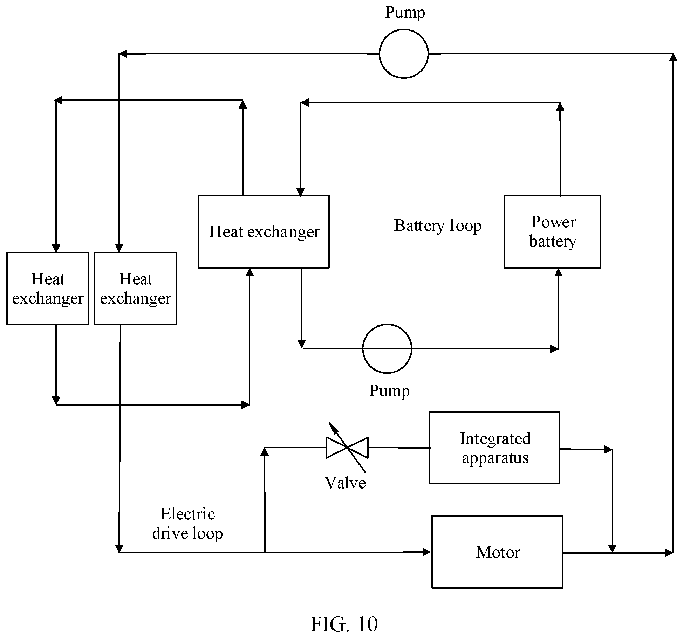

In a possible implementation, the cooling system is applied to a vehicle. FIG. 10 is a diagram of applying the cooling system to a vehicle according to an embodiment of this application. The cooling system includes an electric drive loop and a battery loop. A heat exchange medium circulates in the loop. An arrow direction in the figure is a flow direction of the heat exchange medium, and heat is dissipated to the outside via a heat exchanger and circulates in different loops. When the vehicle is started, an initial temperature of the heat exchange medium is low. In this case, there is a risk of condensation when the heat exchange medium enters the integrated apparatus. Therefore, the valve is closed, so that the integrated apparatus is in a heat dissipation mode like natural heat dissipation or air cooling heat dissipation. When the vehicle runs for a period of time, a power battery and a motor generate heat, so that the temperature of the heat exchange medium in the loop increases, and there is no condensation risk. The valve is opened, so that the integrated apparatus is in a liquid cooling heat dissipation mode. A pump is configured to drive the heat exchange medium to flow in the loop.

Optionally, the first threshold is related to performance of a temperature sensor and/or performance of a humidity sensor, and a temperature and humidity measured by the temperature sensor and the humidity sensor may have errors. To ensure that no condensation is generated in the integrated apparatus and improve reliability of anti-condensation, the first threshold is set, to prevent a measured dew point temperature from being lower than an actual dew point temperature, which is misjudged as no condensation risk. As a result, the integrated apparatus is in a liquid cooling state and condensation is generated.

Optionally, the first threshold is related to a dew point calculation method, and different dew point calculation methods have different error ranges. The first threshold is set to avoid misjudgment of a condensation risk caused by an error, and improve reliability of anti-condensation.

In a possible implementation, when the temperature of the heat exchange medium is not higher than the dew point temperature, or the temperature of the heat exchange medium is not higher than the sum of the dew point temperature and the first threshold, the valve is closed. When the temperature of the heat exchange medium does not meet a condition, there is a risk of condensation. The valve is closed, so that the integrated apparatus is in another heat dissipation state like a natural heat dissipation state or an air cooling state, to prevent condensation.

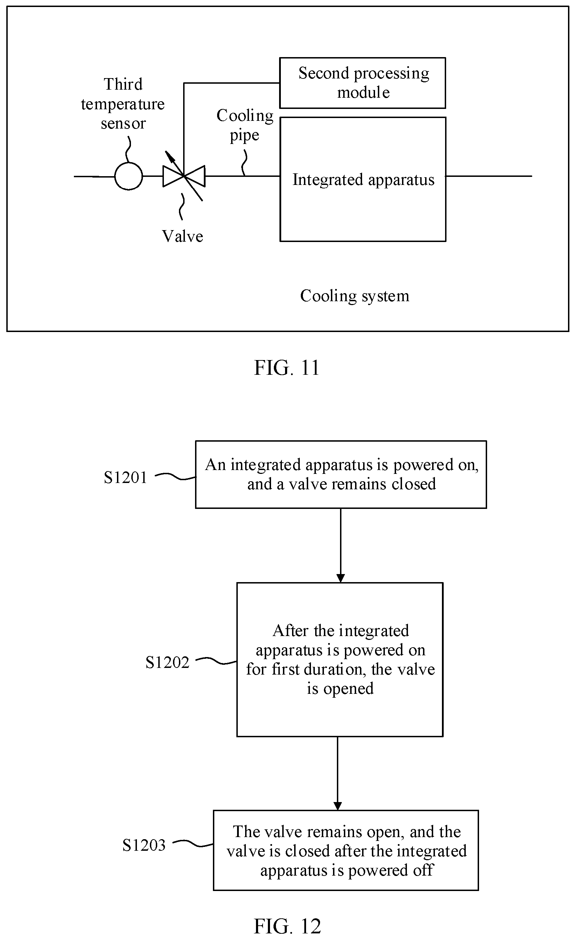

In a possible implementation, FIG. 11 is a diagram of a cooling system according to this application. The cooling system further includes a third temperature sensor, and the third temperature sensor is configured to measure the temperature of the heat exchange medium. A condensation risk may be determined based on the measured temperature of the heat exchange medium, and the cooling mode of the integrated apparatus may be determined. The heat exchange medium first flows through the third temperature sensor, and then flows through the valve.

An embodiment of this application provides a cooling method. FIG. 12 is a schematic flowchart of a cooling method according to this application. The cooling method is applied to a cooling system. The cooling system may be the cooling system shown in any one of FIG. 8, FIG. 9, and FIG. 11. The cooling system includes an integrated apparatus which may be the integrated apparatus shown in any one of FIG. 2 to FIG. 7, a cooling pipe, a valve, and a heat exchange medium. The process is performed according to the following steps. Step 1: S1201: The integrated apparatus is powered on, and the valve remains closed. Step 2: S1202: After the integrated apparatus is powered on for first duration, the valve is opened, the heat exchange medium circulates in the cooling pipe, and the heat exchange medium dissipates heat from the integrated apparatus. Step 3: S1203: The valve remains opened, and the valve is closed after the integrated apparatus is powered off. When the integrated apparatus is powered on, a temperature of the heat exchange medium is low. In this case, when the heat exchange medium circulates to dissipate heat from the integrated apparatus, there is a risk of condensation. After the first duration, the temperature of the heat exchange medium rises to a temperature higher than a dew point temperature, the valve is opened so that the heat exchange medium circulates in the cooling pipe to dissipate heat from the integrated apparatus, and no condensation is generated.

In a possible implementation, the first duration is related to a user of the cooling system, for example, a vehicle. A structure, performance, and a working condition of the user all affect the first duration. For example, when the cooling system is applied to a vehicle, after the vehicle that generates a large amount of heat is started, the temperature of the heat exchange medium rapidly rises to a temperature range without a condensation risk, and the first duration required by the vehicle is shorter than duration required by a vehicle that generates a small amount of heat. For another example, when the vehicle travels in a high-speed working condition, a large amount of heat is generated, and the first duration of the vehicle is shorter than first duration of the vehicle traveling at a low speed.

In a possible implementation, the cooling system is installed on the vehicle. After the vehicle is started, the temperature of the heat exchange medium increases. After the first duration, the temperature of the heat exchange medium increases to a temperature range without a condensation risk, the valve is opened, and the heat exchange medium circulates in the cooling pipe, to enable the integrated apparatus to be in a liquid cooling state.

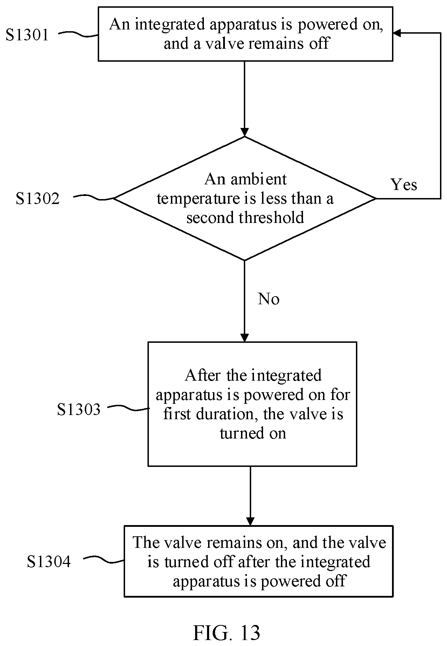

This application provides a cooling method. FIG. 13 is a schematic flowchart of a cooling method according to this application. The cooling method is applied to a cooling system. The cooling system may be the cooling system shown in any one of FIG. 8, FIG. 9, and FIG. 11. The cooling system includes an integrated apparatus, which may be the integrated apparatus shown in any one of FIG. 2 to FIG. 7, a cooling pipe, a valve, and a heat exchange medium. The process is performed according to the following steps. Step 1: S1301: The integrated apparatus is powered on and the valve remains closed. Step 2: S1302: Determine whether an ambient temperature of the integrated apparatus is less than a second threshold. If the ambient temperature of the integrated apparatus is less than the second threshold, perform step S1301. If the ambient temperature of the integrated apparatus is not less than the second threshold, perform Step 3: Step S1303: The valve is opened after the integrated apparatus is powered on for first duration. Step 4: S1304: The valve remains open, and the valve is closed after the integrated apparatus is powered off. When the ambient temperature is less than the second threshold, another heat dissipation mode like natural heat dissipation or air cooling heat dissipation can meet a heat dissipation requirement of the integrated apparatus. The valve is closed, so that the heat exchange medium cannot circulate in the cooling pipe, and there is no condensation risk.

In a possible implementation, when the ambient temperature is not less than the second threshold, and power-on duration of the integrated apparatus is greater than the first duration, the valve is opened, the heat exchange medium circulates in the cooling pipe, and the heat exchange medium then dissipates heat from the integrated apparatus. When the ambient temperature is not less than the second threshold, and another heat dissipation mode like natural heat dissipation or air cooling heat dissipation cannot meet a heat dissipation requirement of the integrated apparatus, liquid cooling heat dissipation needs to be performed on the integrated apparatus. When the power-on duration of the integrated apparatus is greater than the first duration, a temperature of the heat exchange medium rises to a temperature higher than a dew point temperature, the valve is opened so that the heat exchange medium circulates in the cooling pipe, to dissipate heat from the integrated apparatus, and no condensation is generated. The second threshold is related to a structure of the cooling system and performance of the integrated apparatus. If the cooling system can still provide heat dissipation effect when no heat exchange medium circulates, a second threshold is higher than a second threshold of a cooling system with poor heat dissipation effect in a case in which no heat exchange medium circulates. If the integrated apparatus generates a small amount of heat, or the integrated apparatus has good high temperature tolerance, a second threshold of the integrated apparatus is higher than a second threshold of an integrated apparatus that generates a large amount of heat or has poor high temperature tolerance.

An embodiment of this application provides a cooling method, applied to an integrated apparatus. The integrated apparatus includes a circuit board, a first temperature sensor, and a humidity sensor. The first temperature sensor is configured to measure a temperature, and humidity sensor is configured to measure humidity. The temperature and the humidity are used to obtain a dew point temperature of an environment in the integrated apparatus, and the dew point temperature is used to determine a cooling mode of the integrated apparatus.

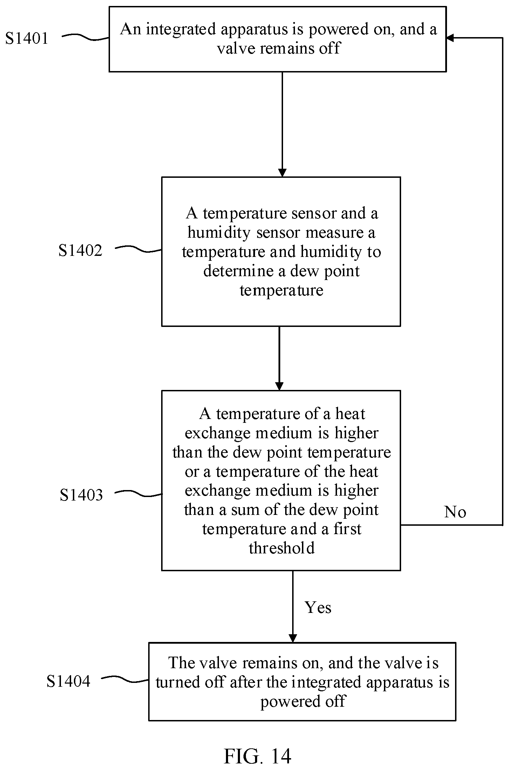

An embodiment of this application provides a cooling method. FIG. 14 is a schematic flowchart of a cooling method according to this application. The cooling method is applied to a cooling system. The cooling system may be the cooling system shown in any one of FIG. 8, FIG. 9, and FIG. 11. The cooling system includes the integrated apparatus according to any one of the first aspect, for example, the integrated apparatus shown in any one of FIG. 2 to FIG. 7, a cooling pipe, a valve, and a heat exchange medium. The cooling pipe is configured to circulate the heat exchange medium, the heat exchange medium is configured to dissipate heat from the integrated apparatus, and the valve is configured to control opening/closing of the cooling pipe. When the valve is opened, the heat exchange medium circulates in the cooling pipe, and the integrated apparatus is in a liquid cooling heat dissipation state. When the valve is closed, the heat exchange medium does not circulate in the cooling pipe, and the integrated apparatus is in another heat dissipation state like natural heat dissipation or air cooling heat dissipation. The process is performed according to the following steps. Step 1: S1401: The integrated apparatus is powered on, and the valve remains closed. Step 2: S1402: A temperature sensor and a humidity sensor measure a temperature and humidity, and determine a dew point temperature. Step 3: S1403: Determine whether a temperature of the heat exchange medium is higher than the dew point temperature or whether a temperature of the heat exchange medium is higher than a sum of the dew point temperature and a first threshold. If the temperature of the heat exchange medium is not higher than the dew point temperature or the temperature of the heat exchange medium is not higher than the sum of the dew point temperature and the first threshold, perform step S1401. If the temperature of the heat exchange medium is higher than the dew point temperature or the temperature of the heat exchange medium is higher than the sum of the dew point temperature and the first threshold, perform Step 4: S1404: The valve remains open, and the valve is closed after the integrated apparatus is powered off.

An embodiment of this application provides a terminal. The terminal includes the integrated apparatus or the cooling system according to any one of the first aspect or the second aspect. Optionally, the terminal is a vehicle.

An embodiment of this application provides a computer-readable storage medium. When the computer-readable storage medium is executed on a computer or a processor, the cooling method in any one of embodiments of this application is performed.

For technical effect of the cooling method and the terminal, refer to descriptions of various implementations of the integrated apparatus, the cooling system, and the cooling method. Details are not described herein again.

The foregoing descriptions about implementations allow a person skilled in the art to understand that, for the purpose of convenient and brief description, division of the foregoing functional modules is taken as an example for illustration. In actual application, the foregoing functions can be allocated to different modules and implemented according to a requirement, that is, an inner structure of an apparatus is divided into different functional modules to implement all or some of the functions described above.

In the several embodiments provided in this application, it should be understood that the disclosed apparatus and method may be implemented in other manners. For example, the described apparatus embodiment is merely an example. For example, the module or division into the units is merely logical function division and may be other division in actual implementation. For example, a plurality of units or components may be combined or integrated into another apparatus, or some features may be ignored or not performed. In addition, the displayed or discussed mutual couplings or direct couplings or communication connections may be implemented through some interfaces. The indirect couplings or the communication connections between the apparatuses or units may be implemented in electronic, mechanical, or other forms.

The units described as separate parts may or may not be physically separate, and parts displayed as units may be one or more physical units, may be located in one place, or may be distributed on different places. Some or all of the units may be selected based on actual requirements to achieve the objectives of the solutions of embodiments.

In addition, functional units in embodiments of this application may be integrated into one processing unit, or each of the units may exist alone physically, or two or more units may be integrated into one unit. The integrated unit may be implemented in a form of hardware, or may be implemented in a form of a software functional unit.

The foregoing descriptions are merely specific implementations of embodiments of this application, but are not intended to limit the protection scope of embodiments of this application. Any variation or replacement within the technical scope disclosed in this application shall fall within the protection scope of embodiments of this application. Therefore, the protection scope of embodiments of this application shall be subject to the protection scope of the claims.

## Claims

1. An integrated apparatus, wherein the integrated apparatus comprises a circuit board, a first temperature sensor, and a humidity sensor;
the first temperature sensor is configured to measure a temperature;
the humidity sensor is configured to measure humidity;
the temperature and the humidity are used to obtain a dew point temperature of an environment in the integrated apparatus; and
the dew point temperature is used to determine a cooling mode of the integrated apparatus.

2. The integrated apparatus according to claim 1, wherein the integrated apparatus further comprises a first processing module, and
the first processing module is configured to calculate the dew point temperature based on the temperature data and the humidity data.

3. The integrated apparatus according to claim 1 or 2, wherein the first temperature sensor is located on the circuit board.

4. The integrated apparatus according to any one of claims 1 to 3, wherein the humidity sensor is located on the circuit board.

5. The integrated apparatus according to any one of claims 1 to 4, wherein the integrated apparatus further comprises a cooling plate and/or a second temperature sensor;
the cooling plate is used for heat exchange of the integrated apparatus; and
the second temperature sensor is configured to measure a temperature of the cooling plate.

6. A cooling system, comprising the integrated apparatus according to any one of claims 1 to 5, a cooling pipe, a valve, and a heat exchange medium, wherein
the cooling pipe is configured to circulate the heat exchange medium;
the heat exchange medium is configured to dissipate heat from the integrated apparatus; and the valve is configured to control opening/closing of the cooling pipe.

7. The cooling system according to claim 6, wherein the cooling system further comprises a second processing module, and
a cooling mode of the integrated apparatus comprises:
when a temperature of the heat exchange medium is higher than a dew point temperature, or a temperature of the heat exchange medium is higher than a sum of a dew point temperature and a first threshold, the second processing module is configured to control the valve to be opened.

8. The cooling system according to claim 7, wherein the first threshold is related to precision of a temperature sensor and/or a humidity sensor.

9. The cooling system according to any one of claims 6 to 8, wherein the valve is closed when the temperature of the heat exchange medium is not higher than the dew point temperature, or the temperature of the heat exchange medium is not higher than the sum of the dew point temperature and the first threshold.

10. The cooling system according to any one of claims 6 to 9, wherein the cooling system further comprises a third temperature sensor, and
the third temperature sensor is configured to measure the temperature of the heat exchange medium.

11. A cooling method, applied to a cooling system, wherein the cooling system comprises an integrated apparatus, a cooling pipe, a heat exchange medium, and a valve, wherein
the integrated apparatus is powered on;
the valve is opened after the integrated apparatus is powered on for first duration;
the cooling pipe circulates the heat exchange medium; and
the heat exchange medium dissipates heat from the integrated apparatus.

12. A cooling method, applied to a cooling system, wherein the cooling system comprises an integrated apparatus, a cooling pipe, a valve, and a heat exchange medium, wherein
an ambient temperature of the integrated apparatus is obtained; and
when the ambient temperature is less than a second threshold, the valve is closed.

13. The cooling method according to claim 12, wherein
when the ambient temperature is not less than the second threshold, if power-on duration of the integrated apparatus is greater than first duration,
the valve is opened;
the cooling pipe circulates the heat exchange medium; and
the heat exchange medium dissipates heat from the integrated apparatus.

14. A cooling method, applied to an integrated apparatus, wherein the integrated apparatus comprises a circuit board, a first temperature sensor, and a humidity sensor, wherein
the first temperature sensor measures a temperature;
the humidity sensor measures humidity;
a dew point temperature of an environment in the integrated apparatus is obtained based on the temperature and the humidity; and
a cooling mode of the integrated apparatus is determined based on the dew point temperature.

15. The cooling method according to claim 14, wherein the integrated apparatus further comprises a first processing module, and
the first processing module calculates the dew point temperature based on the temperature data and the humidity data.

16. The cooling method according to claim 14 or 15, wherein the first temperature sensor is located on the circuit board.

17. The cooling method according to any one of claims 14 to 16, wherein the humidity sensor is located on the circuit board.

18. The cooling method according to any one of claims 14 to 17, wherein the integrated apparatus further comprises a cooling plate and/or a second temperature sensor;
the cooling plate implements heat exchange of the integrated apparatus; and
the second temperature sensor measures temperature data of the cooling plate.

19. A cooling method, applied to a cooling system, wherein the cooling system comprises the integrated apparatus according to any one of claims 1 to 5, a cooling pipe, a valve, and a heat exchange medium;
the cooling pipe circulates the heat exchange medium;
the heat exchange medium dissipates heat from the integrated apparatus; and
the valve controls opening/closing of the cooling pipe.

20. The cooling method according to claim 19, wherein the cooling system further comprises a second processing module, and when a temperature of the heat exchange medium is higher than a dew point temperature, or a temperature of the heat exchange medium is higher than a sum of a dew point temperature and a first threshold, the second processing module controls the valve to be opened.

21. The cooling method according to claim 20, wherein the first threshold is related to precision of a temperature sensor and/or a humidity sensor.

22. The cooling method according to any one of claims 19 to 21, wherein
when the temperature of the heat exchange medium is not higher than the dew point temperature, or the temperature of the heat exchange medium is not higher than the sum of the dew point temperature and the first threshold, the valve is closed.

23. The cooling method according to any one of claims 19 to 22, wherein the cooling system further comprises a third temperature sensor, and
the third temperature sensor measures the temperature of the heat exchange medium.

24. A terminal, wherein the terminal comprises the integrated apparatus according to any one of claims 1 to 5 or the cooling system according to any one of claims 6 to 10.

25. The terminal according to claim 24, wherein the terminal is a vehicle.

26. A computer-readable storage medium, configured to store a computer program, wherein when the computer program is executed on a computer or a processor, the method according to any one of claims 11 to 23 is performed.
